(19) **Europäisches Patentamt**
**European Patent Office**
**Office européen des brevets**

(11) **EP 3 560 002 B1**

(12) **FASCICULE DE BREVET EUROPEEN**

(45) Date de publication et mention
de la délivrance du brevet:
**15.06.2022 Bulletin 2022/24**

(21) Numéro de dépôt: **17837971.5**

(22) Date de dépôt: **20.12.2017**

(51) Classification Internationale des Brevets (IPC):
**H01L 41/193** $^{(2006.01)}$      **H01L 41/45** $^{(2013.01)}$
**H01L 41/37** $^{(2013.01)}$

(52) Classification Coopérative des Brevets (CPC):
**H01L 41/183; H01L 41/257**

(86) Numéro de dépôt international:
**PCT/FR2017/053734**

(87) Numéro de publication internationale:
**WO 2018/115742 (28.06.2018 Gazette 2018/26)**

(54) **COMPOSITES PIÉZOÉLECTRIQUES EN MATRICE SOUPLE**

PIEZOELEKTRISCHE ZUSAMMENSETZUNGEN IN EINER FLEXIBLEN MATRIX

PIEZOELECTRIC COMPOSITES IN A FLEXIBLE MATRIX

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **20.12.2016 FR 1662904**

(43) Date de publication de la demande:
**30.10.2019 Bulletin 2019/44**

(73) Titulaire: **Compagnie Générale des
Etablissements Michelin
63000 Clermont-Ferrand (FR)**

(72) Inventeurs:
 • **ARAUJO DA SILVA, José-Carlos
 63040 Clermont-Ferrand cedex 9 (FR)**
 • **ODDON, Mathieu
 63040 Clermont-Ferrand cedex 9 (FR)**

(74) Mandataire: **Bocchi, Brigitte
M. F. P. Michelin
23, place des Carmes-Déchaux
Service juridique - Propriété Intellectuelle
DCJ/PI - F35 - Site de Ladoux
63040 Clermont-Ferrand Cedex 9 (FR)**

(56) Documents cités:
**EP-A1- 2 654 094      WO-A1-2016/157092
WO-A1-2018/029549    WO-A1-2018/070483
US-A1- 2015 134 061**

• **Wong Y-W ET AL: "Electrostriction of composites
of polyurethane (PU) with ferroelectric lead
zirconate titanate (PZT) ceramic particles",
Proceedings of SPIE, vol. 4329, 1 January 2001
(2001-01-01), pages 516-521, XP055749066, 1000
20th St. Bellingham WA 98225-6705 USA ISSN:
0277-786X, DOI: 10.1117/12.432687 ISBN:
978-1-5106-3927-0**

**Description**

La présente invention concerne un composite piézoélectrique dont la matrice polymérique comprend un élastomère thermoplastique.

La piézoélectricité se développe dans des matériaux tels que les cristaux, certains polymères semi-cristallins et des céramiques piézoélectriques. Ce phénomène physique correspond à l'apparition d'une polarisation électrique induite par une déformation mécanique extérieure. Il s'agit d'un couplage électromécanique où la polarisation est proportionnelle à la contrainte mécanique appliquée jusqu'à un certain niveau. L'effet piézoélectrique est alors dit direct. Ce phénomène est réversible : lorsque le matériau est soumis à un champ électrique extérieur, il se déforme. Il s'agit de l'effet piézoélectrique inverse.

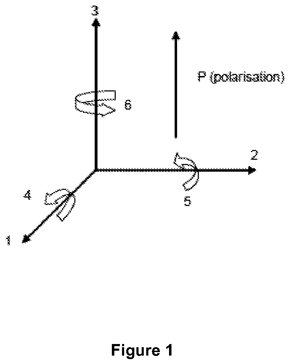

Une variation de la polarisation macroscopique lors de l'application d'une contrainte sur l'échantillon caractérise l'effet piézoélectrique. Dans un système d'axes orthogonaux, la polarisation et la contrainte sont liées en notation matricielle par un tenseur de rang 2 appelé tenseur piézoélectrique $d_{ij}$ avec i=1, 2, 3 et j=1, 2, 3, 4, 5, 6, correspondant respectivement à l'axe de polarisation et d'application de la contrainte comme indiqué sur la figure 1.

Un composite piézoactif ou piézoélectrique comprend au moins un matériau piézoélectrique, qui confère au composite son activité piézoélectrique, et une ou plusieurs phases non piézoélectriques. Cette association conduit à un matériau dont les performances sont accrues par rapport à chaque phase seule. La phase non piézoélectrique est en général une matrice polymère organique, notamment une matrice polymère rigide thermoplastique ou thermodurcissable (US 2015134061, WO 2016/157092), qui peut être de type polyamide (Capsal et al. Journal of non-crystalline solids 2010, 356, 629-634), polyépoxy (Furukawa et al. Jpn. J. Appl. Phys. 1976, 15, 2119), polystyrène, polyuréthane (Hanner et al. Ferroelectrics 1989, 100, 255-260), PVC (Liu et al. Materials Science and Engineering 2006, 127, 261-266) ou encore polyéthylène (Rujijanagul et al. Journal of Materials Science Letters 2001, 20, 1943-1945), ou une matrice polymérique comprenant de l'alcool polyvinylique cyanoéthylé (EP 2654094). Ainsi, un composite piézoélectrique permet de maximiser l'électroactivité de la matrice polymère, mais généralement cette association restreint également sa gamme de déformation.

Dans le domaine des pneumatiques, des dispositifs incluant des composites piézoélectriques sont utilisés comme appareil de production d'énergie à l'intérieur d'un pneu Ces dispositifs permettent de remplacer des batteries conventionnelles à durée limitée. Notamment, le matériau piézoélectrique peut être incrusté dans une matrice époxy (WO 03/095244 Michelin) ou bien dans une matrice polymère thermoplastique, plastique ou piézoélectrique (US 2011/0074564).

Le document WO2016/157092 décrit un composition piézoélectrique comprenant une matrice polymérique et des charges inorganiques piézoélectriques sous forme de particules non liées à la matrice polymérique, dispersée dans la matrice polymérique, la matrice polymérique comprend un élastomère thermoplastique, l'ABS.

Le document EP 2 654 094 décrit des composites piézoélectriques comprenant des céramiques piézoélectriques et une matrice polymérique comprenant de l'alcool polyvinylique cyanoéthylé.

Le document US2010/134061 décrit des composites piézoélectriques comprenant des céramiques piézoélectriques et une matrice polymérique dans lesquels la dispersion de céramiques piézoélectriques est modelée de façon particulière. La matrice polymérique peut comprendre des polymères thermodurcissables et/ou thermoplastiques.

Le document Wong Y-W et al. « Electrostriction of composites of polyurethane (PU) with ferroelectric lead zirconate titanate (PZT) ceramic particles", vol. 4320, 1 janvier 2001, p. 516-521, décrit un composite piézoélectrique comprenant une matrice polymérique (PU) et des charges inorganiques piézoélectriques (PZT) sous forme de particules non liées à la matrice polymérique, dispersées dans ladite matrice polymérique, la matrice polymérique comprend un élastomère thermoplastique (PU).

La présente invention a pour objet un composite piézoélectrique comprenant une matrice polymérique et des charges inorganiques piézoélectriques sous forme de particules non liées à la matrice polymérique, dispersées dans ladite matrice polymérique, caractérisé en ce que la matrice polymérique comprend un élastomère thermoplastique (TPE), qui est un copolymère choisi parmi le groupe suivant, constitué de copolymères diblocs, triblocs linéaires ou étoilés : styrène/butadiène (SB), styrène/isoprène (SI), styrène/butadiène/isoprène (SBI), styrène/butadiène/styrène (SBS), styrène/isoprène/styrène (SIS), styrène/butadiène/isoprène/styrène (SBIS) et les mélanges de ces copolymères, en ce que la température de transition vitreuse, $T_g$, de chaque bloc thermoplastique de l'élastomère thermoplastique (TPE) est inférieure à la température de Curie, $T_c$, la plus faible des charges inorganiques piézoélectriques, en outre lorsque les blocs thermoplastiques ont une température de fusion, $T_f$, ladite température de fusion de chaque bloc thermoplastique est également inférieure à la température de Curie la plus faible des charges inorganiques piézoélectriques, et en ce que le taux de charge des charges inorganiques piézoélectriques est d'au moins 5% en volume par rapport au volume total de matrice polymérique.

Un composite piézoélectrique en matrice souple selon l'invention présente des propriétés électroactives et mécaniques particulières. Sa formulation permet de conférer souplesse et élasticité au matériau composite tout en conservant un caractère piézoélectrique suffisant pour son application dans un dispositif électronique.

Les propriétés électromécaniques particulières du composite électroactif selon l'invention telles que sa souplesse, son élasticité, sa thermoplasticité et sa génération de charges électriques présentent des avantages majeurs par rapport aux composites électroactifs en matrice thermodurcissable ou thermoplastique.

- La thermoplasticité permet une processabilité et une mise en forme au-dessus du point de ramollissement plus facile, en particulier avec une géométrie de l'état de surface contrôlée pour appliquer des électrodes collectrices des charges électriques.
- La thermoplasticité permet également une résistance aux chocs.
- L'absence de liaison covalente entre la matrice et la charge permet un recyclage des composants du composite.
- L'élasticité permet des points de fonctionnement différents impossible avec des matrices thermodurcissables ou thermoplastiques cassants ou présentant une déformation plastique.
- La génération de charges électriques à polarisation identique est plus importante avec une contrainte plus faible.

De plus, lorsque chaque bloc thermoplastique de l'élastomère thermoplastique possède une température de transition vitreuse, Tg, inférieure à la température de Curie, Tc, de la céramique piézoélectrique, la polarisation peut avoir lieu à une température qui rendra le phénomène plus efficace.

Avantageusement, la température de transition vitreuse, et éventuellement la température de fusion des blocs thermoplastiques de l'élastomère thermoplastique TPE, est supérieure ou égale à 80°C.

En particulier, la température de transition vitreuse des blocs élastomères de l'élastomère thermoplastique TPE est inférieure à 25°C.

Avantageusement, l'élastomère thermoplastique TPE est un copolymère SIS.

En particulier, le taux de charges inorganiques piézoélectriques varie de 5% à 80% de volume par rapport au volume total de matrice polymérique, avantageusement de 5% à 60%, plus avantageusement encore de 5% à 30%.

En particulier, la taille des charges inorganiques piézoélectriques varie de 50 nm à 500 $\mu$m.

Avantageusement, les charges inorganiques piézoélectriques sont des céramiques piézoélectriques, en particulier des oxydes ferroélectriques, avantageusement ayant une structure perovskite. Notamment, les charges inorganiques piézoélectriques sont choisies dans le groupe comprenant des charges de titanate de baryum, titanate de plomb, titano-zirconate de plomb (PZT), niobate de plomb, niobate de lithium et niobate de potassium, avantageusement les charges inorganiques piézoélectriques sont des charges de titanate de baryum.

En particulier, les élastomères thermoplastiques TPE représentent au moins 90% en poids par rapport au poids total de la matrice polymérique, avantageusement au moins 95% en poids, plus avantageusement encore 100% en poids.

L'invention a également pour objet un procédé de préparation d'un composite piézoélectrique selon l'invention comprenant une étape de polarisation du composite.

Avantageusement, la température de polarisation est comprise entre la température de transition vitreuse, Tg, de chaque bloc thermoplastique de la matrice TPE et au moins 5°C de moins que la température de Curie, Tc, des charges inorganiques piézoélectriques.

En particulier, la température de polarisation est comprise entre la température de transition vitreuse, Tg, de chaque bloc thermoplastique de la matrice TPE et au moins 7°C de moins que la température de Curie, Tc, des charges inorganiques piézoélectriques, avantageusement au moins 10°C de moins que la température de Curie, Tc, la plus faible des charges inorganiques piézoélectriques.

L'invention a également pour objet un dispositif comprenant le composite piézoélectrique selon l'invention et des électrodes.

L'invention a également pour objet un pneumatique comprenant le dispositif mentionné ci-dessus comprenant le composite piézoélectrique selon l'invention et des électrodes. En particulier, ledit dispositif est fixé sur la couche étanche intérieure dudit pneumatique.

L'invention a également pour objet l'utilisation dudit dispositif mentionné ci-dessus en association avec un capteur.

**Mesures et tests utilisés**

- Confection des éprouvettes

Les éprouvettes de mesure sont de forme rectangulaire et présentent une épaisseur de quelques millimètres. Le matériau composite est mis en forme par pressage à chaud puis découpé aux dimensions souhaitées.

Pour faciliter la polarisation et permettre la mesure, les éprouvettes sont métallisées sur les faces inférieures et supérieures. La métallisation peut être réalisée manuellement avec une laque d'argent ou par pulvérisation cathodique ou toute autre méthode connue de l'homme de l'art.

- Polarisation des échantillons

Le signal de sortie d'un générateur à faible intensité est appliqué aux bornes de l'éprouvette (i.e. connecté aux 2 faces métallisées). Les éprouvettes sont ainsi polarisées sous un champ électrique continu de 4 kV, à la température de 100°C et pendant 60 minutes. Une fois polarisé, l'échantillon est court-circuité pour évacuer un maximum de charges résiduelles.

- Matériel et mesure

La mesure de la réponse électromécanique de ces matériaux s'effectue sur un banc de mesures dynamiques. L'échantillon est pré-étiré de 1% puis il est sollicité en extension de 1 à 2% en déformation à la fréquence de 1Hz et à température ambiante.
Le signal généré par le piézocomposite est récupéré aux bornes de l'échantillon par un appontage de mors spécifique, puis amplifié et mesuré sur un oscilloscope.
A partir de la tension crête crête lue sur l'oscilloscope, on en déduit la charge Q (pC) libérée à chaque sollicitation mécanique. Ainsi le coefficient piézoélectrique d31 (pC/N) peut être calculé. Le coefficient d31, connu de l'homme de l'art, représente le coefficient mesuré par application d'une contrainte dans la direction orthogonale à la direction de polarisation de l'échantillon. Dans le cas d'un échantillon parallélépipédique, la direction de polarisation correspond à la plus faible épaisseur (direction 3) et l'application de la contrainte se fait selon la plus grande longueur (direction 1).
La notation suivante peut être adoptée :

$$d31 = \Delta P3 / \Delta\sigma1,$$

avec $\Delta P3$ la variation de polarisation macroscopique dans la direction 3 et $\Delta\sigma1$ la contrainte appliquée dans la direction 1.
Le calcul de ce coefficient se fait par la formule suivante :

$$d31 = [Q\ (pC) \times \text{épaisseur (m)}] / [\text{Force (N)} \times \text{Longueur (m)}]$$

dans le cas où l'électrode couvre l'entièreté de la surface de l'éprouvette.

**Description détaillée**

Dans la présente description, tout intervalle de valeurs désigné par l'expression « de a à b » représente le domaine de valeurs allant de a jusqu'à b (c'est-à-dire bornes a et b incluses). Tout intervalle « entre a et b » représente le domaine de valeurs allant de plus de a à moins de b (c'est-à-dire bornes a et b exclues).
Par particules non liées à la matrice polymérique on entend des particules sans liaisons covalentes entre la charge inorganique piézoélectrique et la matrice polymérique.
Par « pce », on entend « parties en poids pour cent parties d'élastomère », l'élastomère thermoplastique TPE étant ici inclus dans les élastomères.

1.1 Elastomère thermoplastique (TPE)

Les élastomères thermoplastiques (en abrégé « TPE ») ont une structure intermédiaire entre polymères thermoplastiques et élastomères. Ce sont des copolymères à blocs, constitués de blocs rigides, thermoplastiques, reliés par des blocs souples, élastomères.
L'élastomère thermoplastique utilisé pour la mise en œuvre de l'invention est un copolymère à blocs dont la nature chimique des blocs thermoplastiques et des blocs élastomères peut varier.

1.1.1. Structure du TPE

La masse moléculaire moyenne en nombre (notée Mn) du TPE est préférentiellement comprise entre 30 000 et 500 000 g/mol, plus préférentiellement comprise entre 40 000 et 400 000 g/mol. En dessous des minima indiqués, la cohésion entre les chaînes d'élastomère du TPE, notamment en raison de sa dilution éventuelle (en présence d'une huile d'extension), risque d'être affectée ; d'autre part, une augmentation de la température d'usage risque d'affecter les propriétés mécaniques, notamment les propriétés à la rupture, avec pour conséquence une performance diminuée "à chaud". Par ailleurs, une masse Mn trop élevée peut être pénalisante pour la mise en œuvre. Ainsi, on a constaté qu'une valeur comprise dans un domaine de 50 000 à 300 000 g/mol était particulièrement bien adaptée.

La masse moléculaire moyenne en nombre (Mn) de l'élastomère TPE est déterminée de manière connue, par chromatographie d'exclusion stérique (SEC). Par exemple dans le cas des élastomères thermoplastiques styréniques, l'échantillon est préalablement solubilisé dans du tétrahydrofuranne à une concentration d'environ 1 g/l ; puis la solution est filtrée sur filtre de porosité 0,45 $\mu$m avant injection. L'appareillage utilisé est une chaîne chromatographique « WATERS alliance ». Le solvant d'élution est le tétrahydrofuranne, le débit de 0,7 ml/min, la température du système de 35°C et la durée d'analyse de 90 min. On utilise un jeu de quatre colonnes WATERS en série, de dénominations commerciales « STYRAGEL » (« HMW7 », « HMW6E » et deux « HT6E »). Le volume injecté de la solution de l'échantillon de polymère est de 100 $\mu$l. Le détecteur est un réfractomètre différentiel «WATERS 2410» et son logiciel associé d'exploitation des données chromatographiques est le système « WATERS MILLENIUM ». Les masses molaires moyennes calculées sont relatives à une courbe d'étalonnage réalisée avec des étalons de polystyrène. Les conditions sont adaptables par l'homme du métier.

La valeur de l'indice de polydispersité Ip (rappel : Ip = Mw/Mn avec Mw masse moléculaire moyenne en poids et Mn masse moléculaire moyenne en nombre) du TPE est de préférence inférieure à 3 ; plus préférentiellement inférieure à 2 et encore plus préférentiellement inférieure à 1,5.

De manière connue, les TPE présentent deux pics de température de transition vitreuse (Tg, mesurée selon ASTM D3418), la température la plus basse étant relative à la partie élastomère du TPE, et la température la plus haute étant relative à la partie thermoplastique du TPE. Ainsi, les blocs souples des TPE se définissent par une Tg inférieure à la température ambiante (25°C), tandis que les blocs rigides ont une Tg supérieure à 80°C.

Pour être de nature à la fois élastomère et thermoplastique, le TPE doit être muni de blocs suffisamment incompatibles (c'est-à-dire différents du fait de leur masse, de leur polarité ou de leur Tg respectives) pour conserver leurs propriétés propres de bloc élastomère ou thermoplastique.

Les TPE peuvent être des copolymères avec un petit nombre de blocs (moins de 5, typiquement 2 ou 3), auquel cas ces blocs ont de préférence des masses élevées, supérieures à 15000 g/mol. Ces TPE peuvent être par exemple des copolymères diblocs, comprenant un bloc thermoplastique et un bloc élastomère. Ce sont souvent aussi des élastomères triblocs avec deux segments rigides reliés par un segment souple. Les segments rigides et souples peuvent être disposés linéairement, en étoile ou branchés. Typiquement, chacun de ces segments ou blocs contient souvent au minimum plus de 5, généralement plus de 10 unités de base (par exemple unités styrène et unités butadiène pour un copolymère blocs styrène/ butadiène/ styrène).

On décrit également des TPE qui peuvent aussi comprendre un grand nombre de blocs (plus de 30, typiquement de 50 à 500) plus petits, auquel cas ces blocs ont de préférence des masses peu élevées, par exemple de 500 à 5000 g/mol, ces TPE seront appelés TPE multiblocs par la suite, et sont un enchaînement blocs élastomères - blocs thermoplastiques.

Selon une première variante, le TPE se présente sous une forme linéaire. Par exemple, le TPE est un copolymère dibloc : bloc thermoplastique / bloc élastomère. Le TPE peut aussi être un copolymère tribloc : bloc thermoplastique / bloc élastomère / bloc thermoplastique, c'est-à-dire un bloc élastomère central et de deux blocs thermoplastiques terminaux, à chacune des deux extrémités du bloc élastomère.

Selon une autre variante de l'invention, le TPE utile pour les besoins de l'invention se présente sous une forme étoilée à au moins trois branches. Par exemple, le TPE peut alors se composer d'un bloc élastomère étoilé à au moins trois branches et d'un bloc thermoplastique, situé à l'extrémité de chacune des branches du bloc élastomère. Le nombre de branches de l'élastomère central peut varier, par exemple de 3 à 12, et de préférence de 3 à 6.

On décrit également un TPE qui se présente sous une forme branchée ou dendrimère. Le TPE peut alors se composer d'un bloc élastomère branché ou dendrimère et d'un bloc thermoplastique, situé à l'extrémité des branches du bloc élastomère dendrimère.

1.1.2. Nature des blocs élastomères

Les blocs élastomères du TPE pour les besoins de l'invention, peuvent être tous les élastomères connus de l'homme de l'art. Ils possèdent de préférence une Tg inférieure à 25°C, préférentiellement inférieure à 10°C, plus préférentiellement inférieure à 0°C et très préférentiellement inférieure à -10°C. De manière préférentielle également, la Tg bloc élastomère du TPE est supérieure à -100°C.

Pour les blocs élastomères à chaîne carbonée, si la partie élastomère du TPE ne comporte pas d'insaturation éthylénique, on parlera d'un bloc élastomère saturé. Si le bloc élastomère du TPE comporte des insaturations éthyléniques (c'est-à-dire des doubles liaisons carbone - carbone), on parlera alors d'un bloc élastomère insaturé ou diénique.

On décrit ici ces blocs.

Un bloc élastomère saturé est constitué d'une séquence de polymère obtenu par la polymérisation d'au moins un (c'est-à-dire un ou plusieurs) monomère éthylénique, c'est-à-dire comportant une double liaison carbone - carbone. Parmi les blocs issus de ces monomères éthyléniques, on peut citer les blocs polyalkylènes tels que les copolymères statistiques éthylène - propylène ou éthylène - butylène. Ces blocs élastomères saturés peuvent aussi être obtenus par hydrogénation de blocs élastomères insaturés. Il peut aussi s'agir de blocs aliphatiques issus de la famille des polyéthers, des polyesters, ou des polycarbonates.

Dans le cas des blocs élastomères saturés, ce bloc élastomère du TPE est de préférence composé majoritairement d'unités éthyléniques. Par majoritairement, on entend un taux pondéral en monomère éthylénique le plus élevé par rapport au poids total du bloc élastomère, et de préférence un taux pondéral de plus de 50%, plus préférentiellement de plus de 75% et encore plus préférentiellement de plus de 85%.

Des diènes conjugués en $C_4$ - $C_{14}$ peuvent être copolymérisés avec les monomères éthyléniques. Il s'agit dans ce cas de copolymères statistiques. De préférence, ces diènes conjugués sont choisis parmi l'isoprène, le butadiène, le 1-méthylbutadiène, le 2-méthylbutadiène, le 2,3-diméthyl-1,3-butadiène, le 2,4-diméthyl-1,3-butadiène, le 1,3-pentadiène, le 2-méthyl-1,3-pentadiène, le 3-méthyl-1,3-pentadiène, le 4-méthyl-1,3-pentadiène, le 2,3-diméthyl-1,3-pentadiène, le 1,3-hexadiène, le 2-méthyl-1,3-hexadiène, le 3-méthyl-1,3-hexadiène, le 4-méthyl-1,3-hexadiène, le 5-méthyl-1,3-hexadiène, le 2,3-diméthyl-1,3-hexadiène, le 2,4-diméthyl-1,3-hexadiène, le 2,5-diméthyl-1,3-hexadiène, le 2-neopentylbutadiène, le 1,3-cyclopentadiène, le 1,3-cyclohexadiène, 1-vinyl-1,3-cyclohexadiène ou leur mélange. Plus préférentiellement le diène conjugué est l'isoprène ou un mélange contenant de l'isoprène.

Dans le cas des blocs élastomères insaturés, ce bloc élastomère du TPE est de préférence composé majoritairement d'une partie élastomère diénique. Par majoritairement, on entend un taux pondéral en monomère diénique le plus élevé par rapport au poids total du bloc élastomère, et de préférence un taux pondéral de plus de 50%, plus préférentiellement de plus de 75% et encore plus préférentiellement de plus de 85%. Alternativement, l'insaturation du bloc élastomère insaturé peut provenir d'un monomère comportant une double liaison et une insaturation de type cyclique, c'est le cas par exemple dans le polynorbornène.

Préférentiellement, des diènes conjugués en $C_4$ - $C_{14}$ peuvent être polymérisés ou copolymérisés pour constituer un bloc élastomère diénique. De préférence, ces diènes conjugués sont choisis parmi l'isoprène, le butadiène, le pipérylène, le 1-méthylbutadiène, le 2-méthylbutadiène, le 2,3-diméthyl-1,3-butadiène, le 2,4-diméthyl-1,3-butadiène, le 1,3-pentadiène, le 2-méthyl-1,3-pentadiène, le 3-méthyl-1,3-pentadiène, le 4-méthyl-1,3-pentadiène, le 2,3-diméthyl-1,3-pentadiène, le 2,5-diméthyl-1,3-pentadiène, le 2-méthyl-1,4-pentadiène, le 1,3-hexadiène, le 2-méthyl-1,3-hexadiène, le 2-méthyl-1,5-hexadiène, le 3-méthyl-1,3-hexadiène, le 4-méthyl-1,3-hexadiène, le 5-méthyl-1,3-hexadiène, le 2,5-diméthyl-1,3-hexadiène, le 2,5-diméthyl-2,4-hexadiène, le 2-néopentyl-1,3-butadiène, le 1,3-cyclopentadiène, le méthylcyclopentadiène, le 2-méthyl-1,6-heptadiène, le 1,3-cyclohexadiène, 1-vinyl-1,3-cyclohexadiène ou leur mélange. Plus préférentiellement le diène conjugué est l'isoprène ou le butadiène ou un mélange contenant de l'isoprène et/ou du butadiène.

Selon une variante, les monomères polymérisés pour former la partie élastomère du TPE peuvent être copolymérisés, de manière statistique, avec au moins un autre monomère de manière à former un bloc élastomère. Selon cette variante, la fraction molaire en monomère polymérisé autre qu'un monomère éthylénique, par rapport au nombre total de motifs du bloc élastomère, doit être telle que ce bloc garde ses propriétés d'élastomère. Avantageusement la fraction molaire de cet autre co-monomère peut aller de 0 à 50%, plus préférentiellement de 0 à 45% et encore plus préférentiellement de 0 à 40%.

A titre d'illustration, cet autre monomère susceptible de copolymériser avec le monomère premier peut être choisi parmi les monomères éthyléniques tels que définis précédemment (par exemple l'éthylène), les monomères diènes, plus particulièrement, les monomères diènes conjugués ayant 4 à 14 atomes de carbone tels que définis précédemment (par exemple le butadiène), les monomères de type vinylaromatiques ayant de 8 à 20 atomes de carbone tels que définis ci-après ou encore, il peut s'agir d'un monomère tel que l'acétate de vinyle.

Lorsque le co-monomère est de type vinylaromatique, il représente avantageusement une fraction en motifs sur le nombre total de motifs du bloc thermoplastique de 0 à 50%, préférentiellement allant de 0 à 45% et encore plus préférentiellement allant de 0 à 40%. A titre de composés vinylaromatiques conviennent notamment les monomères styréniques cités plus haut, à savoir les méthylstyrènes, le para-tertio-butylstyrène, les chlorostyrènes, les bromostyrènes, les fluorostyrènes ou encore le para-hydroxy-styrène. De préférence, le co-monomère de type vinylaromatique est le styrène.

Selon un mode de réalisation préférentiel de l'invention, les blocs élastomères du TPE présentent au total, une masse moléculaire moyenne en nombre ("Mn") allant de 25 000 g/mol à 350 000g/mol, de préférence de 35 000 g/mol à 250 000 g/mol de manière à conférer au TPE de bonnes propriétés élastomériques.

Le bloc élastomère peut également être un bloc comprenant plusieurs types de monomères éthyléniques, diéniques ou styréniques tels que définis ci-dessus.

Le bloc élastomère peut également être constitué de plusieurs blocs élastomères tels que définis ci-dessus.

1.1.3. Nature des blocs thermoplastiques

On utilisera pour la définition des blocs thermoplastiques la caractéristique de température de transition vitreuse (Tg) du bloc rigide thermoplastique. Cette caractéristique est bien connue de l'homme du métier. Elle permet notamment de choisir la température de mise en œuvre industrielle (transformation). Dans le cas d'un polymère (ou d'un bloc de polymère) amorphe, la température de mise en œuvre est choisie sensiblement supérieure à la Tg. Dans le cas spécifique d'un polymère (ou d'un bloc de polymère) semi-cristallin, on peut observer une température de fusion alors supérieure à la température de transition vitreuse. Dans ce cas, c'est plutôt la température de fusion (Tf) qui permet de choisir la température de mise en œuvre du polymère (ou bloc de polymère) considéré. Ainsi, par la suite, lorsqu'on parlera de « Tg (ou Tf, le cas échéant) », il faudra considérer qu'il s'agit de la température utilisée pour choisir la température de mise œuvre.

Pour les besoins de l'invention, les élastomères TPE comprennent un ou plusieurs bloc(s) thermoplastique(s) ayant de préférence une Tg (ou Tf, le cas échéant) supérieure ou égale à 80°C et constitué(s) à partir de monomères polymérisés. Préférentiellement, ce bloc thermoplastique a une Tg (ou Tf, le cas échéant) comprise dans un domaine variant de 80°C à 250°C. De préférence, la Tg (ou Tf, le cas échéant) de ce bloc thermoplastique est préférentiellement de 80°C à 200°C, plus préférentiellement de 80°C à 180°C.

La proportion des blocs thermoplastiques par rapport au TPE, tel que défini pour la mise en œuvre de l'invention, est déterminée d'une part par les propriétés de thermoplasticité que doit présenter ledit copolymère. Les blocs thermoplastiques ayant une Tg (ou Tf, le cas échéant) supérieure ou égale à 80°C sont préférentiellement présents dans des proportions suffisantes pour préserver le caractère thermoplastique de l'élastomère selon l'invention. Le taux minimum de blocs thermoplastiques ayant une Tg (ou Tf, le cas échéant) supérieure ou égale à 80°C dans le TPE peut varier en fonction des conditions d'utilisation du copolymère. D'autre part, la capacité du TPE à se déformer lors de la préparation du pneu peut également contribuer à déterminer la proportion des blocs thermoplastiques ayant une Tg (ou Tf, le cas échéant) supérieure ou égale à 80°C.

Les blocs thermoplastiques ayant une Tg (ou Tf, le cas échéant) supérieure ou égale à 80°C peuvent être constitués à partir de monomères polymérisés de diverse nature, notamment on décrit les blocs suivants ou leurs mélanges :

- les polyoléfines (polyéthylène, polypropylène)

- les polyuréthannes ;

- les polyamides ;

- les polyesters ;

- les polyacétals ;

- les polyéthers (polyoxyde d'éthylène, polyphénylène éther) ;

- les polysulfures de phénylène ;

- les polyfluorés (FEP, PFA, ETFE) ;

- les polystyrènes (détaillés ci-dessous) ;

- les polycarbonates ;

- les polysulfones ;

- le polyméthylméthacrylate

- le polyétherimide

- les copolymères thermoplastiques tels que le copolymère acrylonitrile-butadiène-styrène (ABS).

On décrit également des blocs thermoplastiques ayant une Tg (ou Tf, le cas échéant) supérieure ou égale à 80°C qui peuvent aussi être obtenus à partir de monomères choisis parmi les composés suivants et leurs mélanges :

- l'acénaphthylène : l'homme de l'art pourra par exemple se référer à l'article de Z. Fodor et J.P. Kennedy, Polymer Bulletin 1992 29(6) 697-705 ;

- l'indène et ses dérivés tels que par exemple le 2-méthylindène, le 3-méthylindène, le 4-méthylindène, les diméthylindène, le 2-phénylindène, le 3-phénylindène et le 4-phénylindène ; l'homme de l'art pourra par exemple se référer au document de brevet US4946899, par les inventeurs Kennedy, Puskas, Kaszas et Hager et aux documents J. E. Puskas, G. Kaszas, J.P. Kennedy, W.G. Hager Journal of Polymer Science Part A : Polymer Chemistry (1992) 30, 41 et J.P. Kennedy, N. Meguriya, B. Keszler, Macromolecules (1991) 24(25), 6572-6577 ;

- l'isoprène, conduisant alors à la formation d'un certain nombre d'unités polyisoprène 1,4-trans et d'unités cyclisées selon un processus intramoléculaire ; l'homme de l'art pourra par exemple se référer aux documents G. Kaszas, J.E. Puskas, .P. Kennedy Applied Polymer Science (1990) 39(1) 119-144 et J.E. Puskas, G. Kaszas, J.P. Kennedy, Macromolecular Science, Chemistry A28 (1991) 65-80.

Les polystyrènes sont obtenus à partir de monomères styréniques. Par monomère styrénique doit être entendu dans la présente description tout monomère comprenant du styrène, non substitué comme substitué ; parmi les styrènes substitués peuvent être cités par exemple les méthylstyrènes (par exemple l'o-méthylstyrène, le m-méthylstyrène ou le p-méthylstyrène, l'alpha-méthylstyrène, l'alpha-2-diméthylstyrène, l'alpha-4-diméthylstyrène ou le diphényléthylène), le para-tertio-butylstyrène, les chlorostyrènes (par exemple l'o-chlorostyrène, le m-chlorostyrène, le p-chlorostyrène, le 2,4-dichlorostyrène, le 2,6-dichlorostyrène ou le 2,4,6-trichlorostyrène), les bromostyrènes (par exemple l'o-bromostyrène, le m-bromostyrène, le p-bromostyrène, le 2,4-dibromostyrène, le 2,6-dibromostyrène ou les 2,4,6-tribromostyrène), les fluorostyrènes (par exemple l'o-fluorostyrène, le m-fluorostyrène, le p-fluorostyrène, le 2,4-difluorostyrène, le 2,6-difluorostyrène ou les 2,4,6-trifluorostyrène) ou encore le para-hydroxy-styrène.

Le taux pondéral de styrène, dans l'élastomère TPE, est avantageusement compris entre 5% et 50%. En dessous du minimum indiqué, le caractère thermoplastique de l'élastomère risque de diminuer de manière sensible tandis qu'au-dessus du maximum préconisé, l'élasticité peut être affectée. Pour ces raisons, le taux de styrène est plus préférentiellement compris entre 10% et 40%.

Le monomère polymérisé tel que défini ci-dessus peut être copolymérisé avec au moins un autre monomère de manière à former un bloc thermoplastique ayant une Tg (ou Tf, le cas échéant) telle que définie ci-dessus.

A titre d'illustration, cet autre monomère susceptible de copolymériser avec le monomère polymérisé, peut être choisi parmi les monomères diènes, plus particulièrement, les monomères diènes conjugués ayant 4 à 14 atomes de carbone, et les monomères de type vinylaromatiques ayant de 8 à 20 atomes de carbone, tels qu'ils sont définis dans la partie concernant le bloc élastomère.

Selon l'invention, les blocs thermoplastiques du TPE présentent au total, une masse moléculaire moyenne en nombre ("Mn") allant de 5 000 g/mol à 150 000g/mol, de manière à conférer au TPE de bonnes propriétés élastomériques et une tenue mécanique suffisante et compatible avec l'utilisation pneumatique.

Le bloc thermoplastique peut également être constitué de plusieurs blocs thermoplastiques tels que définis ci-dessus.

1.1.4. TPE selon l'invention

Selon l'invention, le TPE est un copolymère dont la partie élastomère est insaturée, et qui comporte des blocs styrènes et des blocs diènes, ces blocs diènes étant en particulier des blocs isoprène ou butadiène. Cet élastomère TPE est choisi dans le groupe suivant, constitué de copolymères diblocs, triblocs linéaires ou étoilés : styrène/ butadiène (SB), styrène/ isoprène (SI), styrène/ butadiène/ isoprène (SBI), styrène/ butadiène/ styrène (SBS), styrène/ isoprène/ styrène (SIS), styrène/ butadiène/ isoprène/ styrène (SBIS) et les mélanges de ces copolymères.

A titre d'exemples d'élastomères TPE commercialement disponibles, on peut citer les élastomères de type SIS commercialisés par Kuraray, sous le nom « Hybrar 5125 », ou commercialisés par Kraton sous le nom de « D1161 » ou encore les élastomères de type SBS linéaire commercialisé par Polimeri Europa sous la dénomination « Europrene SOL T 166 » ou SBS étoilé commercialisés par Kraton sous la dénomination « D1184 ». On peut également citer les élastomères commercialisés par la société Dexco Polymers sous la dénomination de « Vector » ( e.g. « Vector 4114 », « Vector 8508 »). 1.1.5. Quantité de TPE dans la matrice polymérique

Si d'éventuels autres élastomères (non thermoplastiques) sont utilisés dans la matrice polymérique, le ou les élastomères TPE constituent la fraction majoritaire en poids ; ils représentent alors au moins 50% en poids, plus préférentiellement au moins 75% en poids par rapport au poids total de la matrice polymérique. De manière préférentielle également, le ou les élastomères TPE représentent au moins 90%, voire 95% (en particulier 100%) en poids par rapport au poids total de la matrice polymérique.

Ainsi, la quantité d'élastomère TPE est comprise dans un domaine qui varie de 50 à 100 pce, de 75 à 100 pce, de 90 à 100 pce, de 95 à 100 pce.

1.2 Elastomère Non Thermoplastique

La matrice polymérique selon l'invention peut comporter au moins un (c'est-à-dire un ou plusieurs) caoutchouc diénique à titre d'élastomère non thermoplastique, ce caoutchouc diénique pouvant être utilisé seul, ou en coupage avec au moins un (c'est-à-dire un ou plusieurs) autre caoutchouc ou élastomère non thermoplastique.

Le taux total d'élastomère non thermoplastique, optionnel, est compris dans un domaine variant de 0 à 50 pce, préférentiellement de 0 à 25 pce, plus préférentiellement de 0 à 10 pce, voire de 0 à 5 pce. De manière très préférentielle également, la matrice polymérique selon l'invention ne contient pas d'élastomère non thermoplastique.

Par élastomère diénique, doit être compris selon l'invention tout polymère issu au moins en partie (i.e., un homopolymère ou un copolymère) de monomères diènes (monomères porteurs de deux doubles liaisons carbone-carbone, conjuguées ou non). On entend plus particulièrement par élastomère diénique susceptible d'être utilisé dans l'invention, un élastomère diénique correspondant à l'une des catégories suivantes:

(a) tout homopolymère obtenu par polymérisation d'un monomère diène conjugué ayant de 4 à 12 atomes de carbone;

(b) tout copolymère obtenu par copolymérisation d'un ou plusieurs des diènes conjugués cités plus bas, entre eux ou avec un ou plusieurs monomères éthyléniquement insaturés;

(c) tout homopolymère obtenu par polymérisation d'un monomère diène non conjugué ayant de 5 à 12 atomes de carbone;

(d) tout copolymère obtenu par copolymérisation d'un ou plusieurs des diènes non conjugués cités plus bas, entre eux ou avec un ou plusieurs monomères éthyléniquement insaturés;

(e) le caoutchouc naturel;

(f) un mélange de plusieurs des élastomères définis en (a) à (f) entre eux.

A titre de monomère diène conjugué approprié pour la synthèse des élastomères, on peut citer le butadiène-1,3 (ci-après désigné butadiène) , le 2-méthyl-1,3-butadiène, les 2,3-di(alkyle en $C_1$ -Cs)- 1,3-butadiènes tels que par exemple le 2,3-diméthyl-1,3-butadiène, le 2,3-diéthyl-1,3- butadiène, le 2-méthyl-3-éthyl-1,3-butadiène, le 2-méthyl-3-isopropyl-1,3-butadiène, un aryl-1,3-butadiène, le 1,3-pentadiène, le 2,4-hexadiène.

A titre de monomère diène non conjugué approprié pour la synthèse élastomères, on peut citer le pentadiène-1,4, l'hexadiène-1,4, l'éthylidène norbornène, le dicyclopentadiène;

A titre de monomères éthyléniquement insaturés susceptible d'intervenir dans la copolymérisation avec un ou plusieurs monomères diéniques, conjugué ou non, pour synthétiser les élastomères, on peut citer:

- les composés vinylaromatiques ayant de 8 à 20 atomes de carbone, comme par exemple le styrène, l'ortho-, méta-, para-méthylstyrène, le mélange commercial vinylmésitylène, le divinylbenzène, le vinylnaphtalène;

- les monooléfines (non aromatiques) comme par exemple l'éthylène et les alpha-oléfines, notamment le propylène, l'isobutène ;

- le (méth)acrylonitrile, les esters (méth)acryliques.

Parmi ceux-ci, le ou les polymères diéniques utilisés dans l'invention sont tout particulièrement choisis dans le groupe des polymères diéniques constitué par les polybutadiènes (en abrégé "BR"), les polyisoprènes (IR) de synthèse, le caoutchouc naturel (NR), les copolymères de butadiène, les copolymères d'isoprène, les copolymères d'éthylène et de diène et les mélanges de ces polymères. De tels copolymères sont plus préférentiellement choisis dans le groupe constitué par les copolymères de butadiène-styrène (SBR), les copolymères d'isoprène-butadiène (BIR), les copolymères d'isoprène-styrène (SIR), les copolymères d'isoprène-butadiène-styrène (SBIR), les caoutchoucs butyls halogénés ou non, et les copolymères d'éthylène et de butadiène (EBR).

1.3 Thermoplastique non élastomère

La matrice polymérique selon l'invention peut comporter au moins un thermoplastique non élastomère.

Le taux total de thermoplastique non élastomère, optionnel, est compris dans un domaine variant de 0 à 50% en poids, préférentiellement entre 0 et 25% en poids, plus préférentiellement entre 0 et 10% en poids, voire 0 et 5% en poids par rapport au poids total de la matrice polymérique. De manière très préférentielle, la matrice polymérique selon l'invention ne contient pas de thermoplastique non élastomère.

Parmi les thermoplastiques non élastomère, on peut citer le polyéthylène basse densité (PEBD), le polypropylène (PP), le polystyrène (PS), le polyméthacrylate de méthyle (PMMA), les polyamides aliphatiques et les polyesters Parmi les polyamides aliphatiques, on peut citer notamment les polyamides 4-6, 6, 6-6, 11 ou 12. Parmi les polyesters, on peut citer par exemple les PET (polyéthylène téréphthalate), PEN (polyéthylène naphthalate), PBT (polybutylène téréphthalate), PBN (polybutylène naphthalate), PPT (polypropylène téréphthalate), PPN (polypropylène naphthalate).

### 1.4 Charges inorganiques piézoélectriques

Les charges inorganiques piézoélectriques comprennent des composés piézoélectriques inorganiques. Il peut s'agir de monocristaux piézoélectriques ou de céramiques piézoélectriques.

Les monocristaux piézoélectriques sont notamment des matériaux piézoélectriques naturels comme le quartz ou la tourmaline. Les cristaux ferroélectriques peuvent posséder une structure en domaines. On peut distinguer les monocristaux monodomaines et polydomaines selon qu'une ou plusieurs directions de polarisation coexistent dans le cristal.

Les céramiques sont des matériaux piézoélectriques à fort couplage électromécanique et haute densité. Les céramiques tirent leur propriété piézoélectrique de leur structure cristalline, à travers l'absence de symétrie de la maille cristalline qui dissocie les centres de gravité des charges positives et négatives, chaque maille constituant alors un dipôle électrique. La maille cristalline possède ainsi un dipôle permanent qui confère à ces matériaux des valeurs de permittivité diélectrique élevées. Les céramiques de synthèse sont en particulier composées d'oxydes ferroélectriques, qui ont pour propriété de posséder une polarisation électrique à l'état spontané, qui peut en outre être renversée par l'application d'un champ électrique extérieur suffisamment intense.

Avantageusement les charges inorganiques piézoélectriques sont des céramiques piézoélectriques.

Avantageusement, les charges inorganiques piézoélectriques sont des oxydes ferroélectriques.

Les oxydes ferroélectriques peuvent notamment être dotés d'une structure pérovskite. Ils répondent avantageusement à une formule générale $ABO_3$ tels que le titanate de baryum ($BaTiO_3$), le titanate de plomb ($PbTiO_3$), le niobate de potassium ($KNbO_3$), le niobate de plomb ($PbNbO_3$), ou le ferrite de bismuth ($BiFeO_3$). Dans cette famille de matériaux piézoélectriques, on peut également citer le titano-zirconate de plomb (PZT) avec une structure $Pb(Zr_xTi_{1-x})O_3$ dans laquelle x est compris entre 0 et 1. Il peut être sous forme pure ou sous forme de semi-conducteur dopé soit avec des dopants accepteurs (pour donner un PZT dit dur ou hard), tels que Fe, Co, Mn, Mg, Al, In, Cr, Sc, Na ou K, soit avec des dopants donneurs (pour donner un PZT dit doux ou soft), tels que La, Nd, Sb, Ta, Nb ou W.

A titre d'exemples non limitatifs, les charges inorganiques piézoélectriques peuvent être choisies dans le groupe comprenant du titanate de baryum, titanate de plomb, titano-zirconate de plomb (PZT), niobate de plomb, niobate de lithium et niobate de potassium, avantageusement les charges inorganiques piézoélectriques sont des charges de titanate de baryum.

Le titanate de baryum, tout comme le niobate de potassium sont des matériaux piézoélectriques sans plomb. Ils ont l'avantage d'être moins toxiques.

Les céramiques piézoélectriques les plus connues sont le titanate de baryum ($BaTiO_3$) et le titanate zirconate de plomb (PZT), qui ont un très bon coefficient électromécanique et présentent des procédés de fabrication variés. Ces derniers (procédé sol-gel, synthèse hydrothermale, calcination, ...) permettent de modifier les propriétés diélectrique, mécanique et piézoélectrique en fonction de l'application visée.

En particulier, les charges ont des tailles de particules comprises entre 50 nm et 500 $\mu$m. La taille des particules correspond au diamètre moyen des particules. La mesure du diamètre moyen est réalisée par analyse microscopique électronique à balayage (MEB). Des clichés sont réalisés sur des échantillons de poudre. Une analyse d'image est réalisée à l'aide d'un logiciel et permet d'accéder au diamètre moyen des particules présentes.

La température de Curie, Tc, d'un matériau piézoélectrique correspond à la température à laquelle le matériau devient paraélectrique. Ainsi, le cycle d'hystérésis caractéristique du matériau piézoélectrique, et qui est obtenu par le tracé de la polarisation en fonction du champ électrique appliqué au matériau, disparaît lorsque la température de Curie est atteinte. La température de Curie est caractéristique du matériau piézoélectrique.

La température de Curie, Tc, des charges inorganiques comprises dans un composite piézoélectrique selon l'invention est supérieure à la température de transition vitreuse, Tg, de chaque bloc thermoplastique de l'élastomère thermoplastique TPE ainsi que de la température de fusion, Tf, desdits blocs thermoplastiques lorsqu'elle existe.

### 1.5 Composite piézoélectrique

La présente invention a pour objet un composite piézoélectrique comprenant des charges inorganiques piézoélectriques dispersées sous forme de particules individuelles dans une matrice polymérique, caractérisé en ce que la matrice polymérique comprend un élastomère thermoplastique (TPE), en ce que la température de transition vitreuse, Tg, de chaque bloc thermoplastique de l'élastomère thermoplastique (TPE) est inférieure à la température de Curie, Tc, la plus faible des charges inorganiques piézoélectriques, en outre lorsque les blocs thermoplastiques ont une température de fusion, Tf, ladite température de fusion de chaque bloc thermoplastique est également inférieure à la température de Curie la plus faible des charges inorganiques piézoélectriques, et en ce que le taux de charge des charges inorganiques piézoélectriques est d'au moins 5% en volume par rapport au volume total de matrice polymérique.

En particulier, le taux de charges inorganiques piézoélectriques varie de 5% à 80% de volume par rapport au volume total de matrice polymérique, avantageusement de 5% à 60%, plus avantageusement encore de 5% à 30%. Le taux de charges inorganiques piézoélectriques est d'au moins 5% de volume, en particulier au moins 6% de volume, voire 7% de volume par rapport au volume total de matrice polymérique.

Avantageusement, le composite piézoélectrique est de connectivité 0-3, comprenant des particules de charges piézoélectriques dispersées dans la matrice polymérique. La connectivité dépend de l'organisation spatiale de chaque phase constitutive du matériau composite. Un changement de connectivité entraîne des modifications majeures des propriétés physiques des composites. Dans le cas de systèmes bi-phasiques, la nature de la connectivité est représentée par deux nombres (le premier pour la céramique, le second pour la matrice). Ils indiquent le nombre de directions connectées par la phase considérée. Ainsi, un composite de connectivité 0-3 correspond à un composite constitué par des grains de poudre piézoélectrique dispersées dans la matrice polymérique. Le principal avantage de ce type de composite est la facilité de la mise en œuvre du procédé, ou encore la facilité de réaliser des formes complexes, telles que des surfaces incurvées.

### 1.6 Polarisation du composite piézoélectrique

L'étape de polarisation du composite piézoélectrique correspond à l'application d'un champ électrique aux bornes du composite électroactif pour orienter les dipôles des charges piézoélectriques dans la même direction afin d'obtenir une polarisation macroscopique du composite.

La polarisation dépend de la température de polarisation, du champ électrique appliqué et du temps de polarisation.

De manière avantageuse, la température de polarisation est supérieure à la température de transition vitreuse, Tg, de chaque bloc thermoplastique de l'élastomère thermoplastique TPE. En effet, au-delà de la température de transition vitreuse de chaque bloc thermoplastique de l'élastomère thermoplastique TPE, la permittivité diélectrique du polymère augmente, favorisant l'adaptation de permittivité entre polymère et particules céramiques.

Avantageusement, la température de polarisation est au moins inférieure de 5°C par rapport à la température de Curie, Tc, la plus faible des charges inorganiques piézoélectriques. En effet, proche de la température de Curie des charges inorganiques piézoélectriques, l'agitation des dipôles rend plus difficile leur alignement sous un champ électrique.

Avantageusement, la température de polarisation est comprise entre la température de transition vitreuse, Tg, de chaque bloc thermoplastique de l'élastomère thermoplastique TPE et 5°C de moins que la température de Curie, Tc, la plus faible des charges inorganiques piézoélectriques.

Avantageusement la température de polarisation est comprise entre la température de transition vitreuse, Tg, de chaque bloc thermoplastique de l'élastomère thermoplastique TPE et au moins 7°C de moins, encore plus avantageusement au moins 10°C de moins que la température de Curie, Tc, la plus faible des charges inorganiques piézoélectriques. En particulier, le champ électrique appliqué lors de l'étape de polarisation est compris entre 0,5 et 8kV/mm, avantageusement entre 0,75 et 4kV/mm.

En particulier le champ électrique appliqué dépend de la nature de la charge piézoélectrique et de la durée de polarisation du composite piézoélectrique. L'homme du métier sait adapter le champ électrique à la charge piézoélectrique et à la durée de polarisation.

En particulier, la durée de polarisation est comprise entre 1 minute et 10 heures, de préférence entre 5 minutes et 2 heures.

### 1.7 Procédé

Le composite piézoélectrique selon l'invention est élaboré à partir d'une matrice polymérique et des charges inorganiques piézoélectriques.

Il peut être obtenu par des moyens de mélangeage en bulk comme l'extrusion ou autre procédé discontinu.

A titre d'exemple, l'élastomère thermoplastique TPE est solubilisé dans un solvant pour obtenir une solution de TPE. Le matériau piézoélectrique est introduit dans la solution TPE pour donner une suspension qui est ensuite agitée. La suspension est sonifiée, puis le solvant est évaporé pour obtenir le composite piézoélectrique selon l'invention.

Le composite piézoélectrique peut aussi être réalisé par extrusion ou dans un mélangeur interne.

1.8 Utilisation

L'invention a notamment pour objet un dispositif comprenant le composite piézoélectrique selon l'invention et des électrodes.

Les électrodes sont connues de l'homme de l'art. Elles sont préférentiellement souples, tels qu'un mélange TPE ou diénique rendu conducteur ou une encre ou laque conductrice. Elles peuvent également être sous forme de dépôt mince de métaux, tel qu'un dépôt fin d'or ou d'argent.

Les électrodes sont déposées sur les faces du composite piézoélectrique selon l'invention afin de collecter les charges émises par ledit composite.

Le dispositif est avantageusement relié à un organe électronique afin de capter les impulsions électriques émises et d'utiliser cette information.

L'invention a également pour objet l'utilisation du dispositif selon mentionné ci-dessus en association avec un capteur.

L'invention a également pour objet un pneumatique comprenant le dispositif mentionné ci-dessus comprenant le composite piézoélectrique selon l'invention et des électrodes. En particulier, ledit dispositif est fixé sur la couche étanche intérieure dudit pneumatique. La fixation peut être réalisée par des moyens classiques connus de l'homme de l'art comme le grattage du badigeon, l'utilisation de vulcanisation à froid ou encore la fusion de TPE. La fixation peut se faire par collage par adhésif.

**Exemples**

Composite :

- Matrice thermoplastique élastomère : copolymère poly(styrène-isoprène-styrène) SIS - D1163 de Kraton (densité = 0,94)
- Charges inorganiques piézoélectriques : $BaTiO_3$ : diamètre moyen 500nm ou 700nm, densité 5,85g/cm$^3$ - Inframat Advanced Materials

Formulation :

- Taux de charge : variable de 0 à 26% en volume par rapport au volume total de matrice polymérique

Procédé de préparation :

- Mélangeage liquide en solvant.
- Forme des éprouvettes : parallélépipède de Longueur x Largeur x Epaisseur : 3x1,5x1 (mm)
- Surface des électrodes sur les éprouvettes : Longueur x Largeur : 2,5x1 (mm)

Conditions de polarisation :

- Temps : 1h
- Température : 100°C
- Champs électrique : 4,5kV/mm

Mesure de la quantité de charge électrique émise :

- DMA Metravib avec mors d'extension spécifique permettant de capter les charges collectées sur les électrodes des composites > Amplificateur de charges > Oscilloscope

- Mode de sollicitation : extension variable de 0,01% à 2% en fonction de la matrice

Exemple 1. Effet du taux de charge

<u>Particules de 500 nm</u> - Sollicitation dynamique : 2% déformation à 1Hz

Tableau 1

| | 1 | 2 | 3 | 4 |
|---|---|---|---|---|
| SIS D1163 (pce) | 100 | 100 | 100 | 100 |
| $BaTiO_3$ (pce) | 0 | 32,8 | 69,1 | 155,6 |
| Fraction vol. $BaTiO_3$ (%vol) | 0 | 5,6 | 11,6 | 26,0 |
| | | | | |
| Q (pC) | 2 | 32 | 69 | 138 |
| d31 (pC/N) | 0,2 | 2,4 | 4,3 | 5,9 |

Particules de 700 nm - Sollicitation dynamique : 2% déformation à 1Hz

Tableau 2

| | 1 | 2 | 3 | 4 |
|---|---|---|---|---|
| SIS D1163 (pce) | 100 | 100 | 100 | 100 |
| $BaTiO_3$ (pce) | 0 | 32,8 | 69,1 | 155,6 |
| Fraction vol. $BaTiO_3$ (%vol) | 0 | 5,6 | 11,6 | 26 |
| | | | | |
| Q (pC) | 2 | 24 | 32 | 72 |
| d31 (pC/N) | 0,2 | 1,7 | 1,9 | 3,0 |

Conclusion : Le taux de particules céramiques ferroélectriques a un impact direct sur le taux de charge électrique restitué pour une même déformation. Le comportement piézoélectrique du composite est observé dès 5% en volume de charges piézoélectriques. Les différents diamètres de particules permettent d'obtenir des composites ayant une activité piézoélectrique.

Exemple 2. Effet du taux de déformation - Comparaison des matrices

- (1) Matrice thermoplastique élastomère (TPE) : copolymère poly(styrène-isoprène-styrène) SIS - D1163 de Kraton (densité = 0,94)
- (2) Matrice thermoplastique (TP) : homopolymère polypropylène -100GA12 d'INEOS (densité=0,92)
- (3) Matrice thermodurcissable (TD) : résine époxy avec durcisseur amine - SR1660 et SD2630 de SICOMIN (densité=1,15 et 1)

    1 (TPE) : exemple selon l'invention.

    2 (TP) et 3 (TD) : exemples comparatifs.

Particules 700 nm - taux de charge : 11% en volume par rapport au volume total de matrice polymérique

Tableau 3

|  | 1 (TPE) | 2 (TP) | 3 (TD) |
|---|---|---|---|
| SIS D1163 (pce) | 100 |  |  |
| PP 100GA12 (pce) |  | 100 |  |
| Résine SR1660 (pce) |  |  | 77 |
| Durcisseur SR2630 (pce) |  |  | 23 |
| BaTiO$_3$ (pce) | 69,2 | 70,7 | 65,0 |
|  |  |  |  |
| d31 (pC/N) selon la déformation |  |  |  |
| 0,01% de déformation | - | - | 0,03 |
| 0,05% de déformation | - | - | 0,02 |
| 0,1% de déformation | 2,0 | 0,0 | 0,02 |
| 0,5% de déformation | 1,6 | 0,01 | Rupture |
| 1% de déformation | 1,5 | 0,01 | - |
| 2% de déformation | 1,8 | Déformation plastique | - |

Conclusion : A un même niveau de déformation mécanique la quantité de charge électrique émise est plus importante dans le cas du composite comprenant une matrice d'élastomère thermoplastique TPE. De plus, la plage d'utilisation en déformation du composite comprenant une matrice d'élastomère thermoplastique TPE est plus importante. En effet, avec une matrice thermodurcissable, le composite est endommagé après 0,1% de déformation, avec une matrice thermoplastique, une déformation plastique non réversible sans apport d'énergie est observée après 1% de déformation. Au contraire, avec une matrice TPE, le composite est utilisable au-dessus de 2% de déformation, la limite dans cet exemple étant lié à la limite d'utilisation de l'électrode qui est plus fragile que le composite à base de TPE.

Exemple 3. Effet de la température de polarisation

Particules 700 nm - taux de charge : 26% en volume par rapport au volume total de matrice polymérique

Tableau 4

|  | 1 | | | | |
|---|---|---|---|---|---|
| SIS D1163 (pce) | 100 | | | | |
| BaTiO$_3$ (pce) | 155,6 | | | | |
|  | | | | | |
| Température de polarisation (°C) | 30 | 55 | 80 | 100 | 120 |
|  | | | | | |
| d31 (pC/N) | 0,1 | 0,1 | 1,8 | 3,0 | 0,7 |

Conclusion : La température de polarisation a un impact sur la quantité de charge émise par le composite piézoélectrique. Avoir une matrice dont les blocs thermoplastiques possèdent une température de transition vitreuse, Tg, inférieure à la température de Curie, Tc, de la céramique ferroélectrique permet de polariser à une température qui rendra le phénomène plus efficace. Dans cet exemple, la Tc des charges piézoélectriques de BaTiO$_3$ est de l'ordre des 130°C.

**Revendications**

**1.** Composite piézoélectrique comprenant une matrice polymérique et des charges inorganiques piézoélectriques sous forme de particules non liées à la matrice polymérique, dispersées dans ladite matrice polymérique, ladite matrice polymérique comprenant un élastomère thermoplastique qui est un copolymère dibloc ou tribloc, linéaire ou étoilé dont la température de transition vitreuse, Tg, de chaque bloc thermoplastique de l'élastomère thermoplastique est inférieure à la température de Curie, Tc, la plus faible des charges inorganiques piézoélectriques, en outre lorsque les blocs thermoplastiques ont une température de fusion, Tf, ladite température de fusion de chaque bloc thermoplastique est également inférieure à la température de Curie la plus faible des charges inorganiques piézoélectriques, et le taux de charge des charges inorganiques piézoélectriques est d'au moins 5% en volume par rapport au volume total de matrice polymérique, **caractérisé en ce que** ledit élastomère thermoplastique est choisi parmi styrène/butadiène, styrène/isoprène, styrène/butadiène/isoprène, styrène/butadiène/styrène, styrène/isoprène/styrène, styrène/butadiène/isoprène/styrène et les mélanges de ces copolymères.

2. Composite piézoélectrique selon la revendication 1 précédentes **caractérisé en ce que** la température de transition vitreuse et la température de fusion des blocs thermoplastiques de l'élastomère thermoplastique est supérieure ou égale à 80°C.

3. Composite piézoélectrique selon l'une quelconque des revendications précédentes **caractérisé en ce que** la température de transition vitreuse des blocs élastomères de l'élastomère thermoplastique est inférieure à 25°C.

4. Composite piézoélectrique selon l'une quelconque des revendications précédentes **caractérisé en ce que** l'élastomère thermoplastique est un copolymère styrène/isoprène/styrène.

5. Composite piézoélectrique selon l'une quelconque des revendications précédentes **caractérisé en ce que** le taux de charges inorganiques piézoélectriques varie de 5% à 80% en volume par rapport au volume total de matrice polymérique, avantageusement de 5% à 60%, plus avantageusement encore de 5% à 30%.

6. Composite piézoélectrique selon l'une quelconque des revendications précédentes **caractérisé en ce que** la taille des charges inorganiques piézoélectriques varie de 50 nm à 500 $\mu$m.

7. Composite piézoélectrique selon l'une quelconque des revendications précédentes **caractérisé en ce que** les charges inorganiques piézoélectriques sont des céramiques piézoélectriques, avantageusement des oxydes ferroélectriques, avantageusement ayant une structure perovskite.

8. Composite piézoélectrique selon l'une quelconque des revendications précédentes **caractérisé en ce que** les charges inorganiques piézoélectriques sont choisies dans le groupe comprenant les charges de titanate de baryum, titanate de plomb, titano-zirconate de plomb (PZT), niobate de plomb, niobate de lithium et niobate de potassium, avantageusement les charges inorganiques piézoélectriques sont des charges de titanate de baryum.

9. Composite piézoélectrique selon l'une quelconque des revendications précédentes **caractérisé en ce que** l'élastomère thermoplastique représente au moins 90% en poids par rapport au poids total de la matrice polymérique, avantageusement au moins 95% en poids, plus avantageusement encore 100% en poids.

10. Procédé de préparation d'un composite piézoélectrique selon l'une quelconque des revendications précédentes comprenant une étape de polarisation du composite.

11. Procédé selon la revendication 10 **caractérisé en ce que** la température de polarisation est comprise entre la température de transition vitreuse, Tg, de chaque bloc thermoplastique de la matrice et au moins 5°C de moins que la température de Curie, Tc, la plus faible des charges inorganiques piézoélectriques.

12. Procédé selon la revendication 10 **caractérisé en ce que** la température de polarisation est comprise entre la température de transition vitreuse, Tg, de chaque bloc thermoplastique de la matrice et au moins 7°C de moins, avantageusement au moins 10°C de moins que la température de Curie, Tc, la plus faible des charges inorganiques piézoélectriques.

13. Dispositif comprenant le composite piézoélectrique selon l'une quelconque des revendications 1 à 9 et des électrodes.

14. Pneumatique comprenant un dispositif selon la revendication 13.

**15.** Utilisation du dispositif selon la revendication 13 en association avec un capteur.

**Patentansprüche**

**1.** Piezoelektrischer Verbundwerkstoff, umfassend eine Polymermatrix und anorganische piezoelektrische Füllstoffe in Form nicht an die Polymermatrix gebundener Partikel, die in der Polymermatrix dispergiert sind, wobei die Polymermatrix ein thermoplastisches Elastomer umfasst, bei dem es sich um ein gerades oder sternförmiges Diblock- oder Triblockcopolymer handelt, wobei die Glasübergangstemperatur, Tg, jedes thermoplastischen Blocks des thermoplastischen Elastomers niedriger ist als die niedrigste Curie-Temperatur, Tc, der piezoelektrischen anorganischen Füllstoffe, wobei außerdem, wenn die thermoplastischen Blöcke eine Schmelztemperatur, Tf, aufweisen, die Schmelztemperatur jedes thermoplastischen Blocks ebenfalls niedriger ist als die niedrigste Curie-Temperatur der piezoelektrischen anorganischen Füllstoffe und der Füllanteil der anorganischen piezoelektrischen Füllstoffe mindestens 5 Vol.-%, bezogen auf das Gesamtvolumen der Polymermatrix, beträgt, **dadurch gekennzeichnet, dass** das thermoplastische Elastomer aus Styrol/Butadien, Styrol/Isopren, Styrol/Butadien/Isopren, Styrol/Butadien/Styrol, Styrol/Isopren/Styrol, Styrol/Butadien/Isopren/Styrol und Gemischen dieser Copolymere ausgewählt ist.

**2.** Piezoelektrischer Verbundwerkstoff nach dem vorhergehenden Anspruch 1, **dadurch gekennzeichnet, dass** die Glasübergangstemperatur und die Schmelztemperatur der thermoplastischen Blöcke des thermoplastischen Elastomers höher als oder gleich 80 °C ist.

**3.** Piezoelektrischer Verbundwerkstoff nach einem der vorhergehenden Ansprüche, **dadurch gekennzeichnet, dass** die Glasübergangstemperatur der Elastomerblöcke des thermoplastischen Elastomers niedriger als 25 °C ist.

**4.** Piezoelektrischer Verbundwerkstoff nach einem der vorhergehenden Ansprüche, **dadurch gekennzeichnet, dass** es sich bei dem thermoplastischen Elastomer um ein Styrol/Isopren/Styrol-Copolymer handelt.

**5.** Piezoelektrischer Verbundwerkstoff nach einem der vorhergehenden Ansprüche, **dadurch gekennzeichnet, dass** der Anteil an piezoelektrischen anorganischen Füllstoffen von 5 Vol.-% bis 80 Vol.-%, bezogen auf das Gesamtvolumen der Polymermatrix, vorteilhafterweise von 5 % bis 60 %, noch vorteilhafter von 5 % bis 30 % variiert.

**6.** Piezoelektrischer Verbundwerkstoff nach einem der vorhergehenden Ansprüche, **dadurch gekennzeichnet, dass** die Größe der piezoelektrischen anorganischen Füllstoffe von 50 nm bis 500 $\mu$m variiert.

**7.** Piezoelektrischer Verbundwerkstoff nach einem der vorhergehenden Ansprüche, **dadurch gekennzeichnet, dass** es sich bei den piezoelektrischen anorganischen Füllstoffen um piezoelektrische Keramiken, vorzugsweise ferroelektrische Oxide, vorzugsweise mit Perowskit-Struktur, handelt.

**8.** Piezoelektrischer Verbundwerkstoff nach einem der vorhergehenden Ansprüche, **dadurch gekennzeichnet, dass** die anorganischen piezoelektrischen Füllstoffe aus der Bariumtitanat-, Bleititanat-, Blei-Zirkonat-Titanat(PZT)-, Bleiniobat-, Lithiumniobat- und Kaliumniobat-Füllstoffe umfassenden Gruppe ausgewählt sind, wobei vorteilhafterweise die anorganischen piezoelektrischen Füllstoffe Bariumtitanat-Füllstoffe sind.

**9.** Piezoelektrischer Verbundwerkstoff nach einem der vorhergehenden Ansprüche, **dadurch gekennzeichnet, dass** das thermoplastische Elastomer mindestens 90 Gew.-%, bezogen auf das Gesamtgewicht der Polymermatrix, vorteilhafterweise mindestens 95 Gew.-%, noch vorteilhafter 100 Gew.-% ausmacht.

**10.** Verfahren zur Herstellung eines piezoelektrischen Verbundwerkstoffs nach einem der vorhergehenden Ansprüche, das einen Schritt der Polarisation des Verbundwerkstoffs umfasst.

**11.** Verfahren nach Anspruch 10, **dadurch gekennzeichnet, dass** die Polarisationstemperatur zwischen der Glasübergangstemperatur, Tg, jedes thermoplastischen Blocks der Matrix und mindestens 5 °C unterhalb der niedrigsten Curie-Temperatur, Tc, der piezoelektrischen anorganischen Füllstoffe liegt.

**12.** Verfahren nach Anspruch 10, **dadurch gekennzeichnet, dass** die Polarisationstemperatur zwischen der Glasübergangstemperatur, Tg, jedes thermoplastischen Blocks der Matrix und mindestens 7 °C unterhalb, vorteilhafterweise mindestens 10 °C unterhalb der niedrigsten Curie-Temperatur, Tc, der piezoelektrischen anorganischen Füllstoffe liegt.

**13.** Vorrichtung, umfassend den piezoelektrischen Verbundwerkstoff nach einem der Ansprüche 1 bis 9 und Elektroden.

**14.** Reifen, umfassend eine Vorrichtung nach Anspruch 13.

**15.** Verwendung der Vorrichtung nach Anspruch 13 in Kombination mit einem Sensor.

**Claims**

**1.** Piezoelectric composite comprising a polymeric matrix and piezoelectric inorganic fillers in the form of particles which are not bound to the polymeric matrix, which are dispersed in said polymeric matrix, said polymeric matrix comprising a thermoplastic elastomer which is a linear or star-branched diblock or triblock copolymer, in that the glass transition temperature, Tg, of each thermoplastic block of the thermoplastic elastomer is lower than the lowest Curie temperature, Tc, of the piezoelectric inorganic fillers, moreover when the thermoplastic blocks have a melting point, Tm, said melting point of each thermoplastic block is also lower than the lowest Curie temperature of the piezoelectric inorganic fillers, and in that the filler content of the piezoelectric inorganic fillers is at least 5% by volume relative to the total volume of polymeric matrix, **characterized in that** the thermoplastic elastomer is selected from styrene/butadiene, styrene/isoprene, styrene/butadiene/isoprene, styrene/butadiene/styrene, styrene/isoprene/styrene, styrene/butadiene/isoprene/styrene and mixtures of these copolymers.

**2.** Piezoelectric composite according to Claim 1, **characterized in that** the glass transition temperature and optionally the melting point of the thermoplastic blocks of the thermoplastic elastomer is greater than or equal to 80°C.

**3.** Piezoelectric composite according to either one of the preceding claims, **characterized in that** the glass transition temperature of the elastomer blocks of the thermoplastic elastomer is less than 25°C.

**4.** Piezoelectric composite according to any one of the preceding claims, **characterized in that** the thermoplastic elastomer is a styrene/isoprene/styrene copolymer.

**5.** Piezoelectric composite according to any one of the preceding claims, **characterized in that** the content of piezoelectric inorganic fillers varies from 5% to 80% by volume relative to the total volume of polymeric matrix, advantageously from 5% to 60%, more advantageously still from 5% to 30%.

**6.** Piezoelectric composite according to any one of the preceding claims, **characterized in that** the size of the piezoelectric inorganic fillers varies from 50 nm to 500 $\mu$m.

**7.** Piezoelectric composite according to any one of the preceding claims, **characterized in that** the piezoelectric inorganic fillers are piezoelectric ceramics, advantageously ferroelectric oxides, advantageously having a perovskite structure.

**8.** Piezoelectric composite according to any one of the preceding claims, **characterized in that** the piezoelectric inorganic fillers are selected from the group comprising barium titanate, lead titanate, lead zirconate titanate (PZT), lead niobate, lithium niobate and potassium niobate fillers, advantageously the piezoelectric inorganic fillers are barium titanate fillers.

**9.** Piezoelectric composite according to any one of the preceding claims, **characterized in that** the thermoplastic elastomer represents at least 90% by weight relative to the total weight of the polymeric matrix, advantageously at least 95% by weight, more advantageously still 100% by weight.

**10.** Process for preparing a piezoelectric composite according to any one of the preceding claims, comprising a step of polarizing the composite.

**11.** Process according to Claim 10, **characterized in that** the polarization temperature is between the glass transition temperature, Tg, of each thermoplastic block of the matrix and at least 5°C lower than the lowest Curie temperature, Tc, of the piezoelectric inorganic fillers.

**12.** Process according to Claim 10, **characterized in that** the polarization temperature is between the glass transition temperature, Tg, of each thermoplastic block of the matrix and at least 7°C lower, advantageously at least 10°C lower, than the lowest Curie temperature, Tc, of the piezoelectric inorganic fillers.

13. Device comprising the piezoelectric composite according to any one of Claims 1 to 9 and electrodes.

14. Tyre comprising a device according to Claim 13.

15. Use of the device according to Claim 13, in combination with a sensor.

**Figure 1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015134061 A
- WO 2016157092 A
- EP 2654094 A
- WO 03095244 A

- US 20110074564 A
- US 2010134061 A
- US 4946899 A

**Littérature non-brevet citée dans la description**

- **CAPSAL et al.** *Journal of non-crystalline solids,* 2010, vol. 356, 629-634
- **FURUKAWA et al.** *Jpn. J. Appl. Phys.,* 1976, vol. 15, 2119
- **HANNER et al.** *Ferroelectrics,* 1989, vol. 100, 255-260
- **LIU et al.** *Materials Science and Engineering,* 2006, vol. 127, 261-266
- **RUJIJANAGUL et al.** *Journal of Materials Science Letters,* 2001, vol. 20, 1943-1945
- **WONG Y-W et al.** *Electrostriction of composites of polyurethane (PU) with ferroelectric lead zirconate titanate (PZT) ceramic particles,* 01 Janvier 2001, vol. 4320, 516-521

- **Z. FODOR ; J.P. KENNEDY.** *Polymer Bulletin,* 1992, vol. 29 (6), 697-705
- **J. E. PUSKAS ; G. KASZAS ; J.P. KENNEDY ; W.G. HAGER.** *Journal of Polymer Science Part A : Polymer Chemistry,* 1992, vol. 30, 41
- **J.P. KENNEDY ; N. MEGURIYA ; B. KESZLER.** *Macromolecules,* 1991, vol. 24 (25), 6572-6577
- **G. KASZAS ; J.E. PUSKAS ; P. KENNEDY.** *Applied Polymer Science,* 1990, vol. 39 (1), 119-144
- **J.E. PUSKAS ; G. KASZAS ; J.P. KENNEDY.** Macromolecular Science. *Chemistry,* 1991, vol. A28, 65-80